# EUROPÄISCHE PATENTSCHRIFT

(11) **EP 2 398 721 B1**
(45) Veröffentlichungstag und Bekanntmachung des Hinweises auf die Patenterteilung: **04.09.2013**
(21) Anmeldenummer: 10711132.0
(22) Anmeldetag: 18.02.2010
(51) Int. Cl.: B65G 47/91, B25J 15/06, B65G 49/06

(54) **VORRICHTUNG UND VERFAHREN ZUM BERÜHRUNGSLOSEN ERFASSEN VON GLASPLATTEN**
DEVICE AND METHOD FOR THE CONTACTLESS SEIZING OF GLASS SHEETS
DISPOSITIF ET PROCÉDÉ DE PRÉHENSION SANS CONTACT DE PANNEAUX DE VERRE

(30) Priorität: 23.02.2009 DE 102009010164
(43) Veröffentlichungstag der Anmeldung: 28.12.2011
(73) Patentinhaber: Grenzebach Maschinenbau GmbH, 86663 Asbach-Bäumenheim (DE)
(72) Erfinder: HERFERT, Christian, 86462 Langweid (DE)
(74) Vertreter: Karl, Frank
(86) Internationale Anmeldenummer: PCT/DE2010/000187
(87) Internationale Veröffentlichungsnummer: WO 2010/094275

(56) Entgegenhaltungen:
- EP-A1- 1 676 794
- DE-A1- 10 352 944
- DE-A1-102006 017 763
- VERLAG MODERNE INDUSTRIE AG: "Berührungslos Greifen" 3. Dezember 2008 (2008-12-03), XP002589145 Gefunden im Internet: URL:http://imperia.mi-verlag.de/imperia/md /content/ai/ae/fachartikel/pr/2008/12/pr08 _12_050.pdf [gefunden am 2019-06-25]
- ZIMMERMANN & SCHILP: "NON-CONTACT HANDLING" 31. Dezember 2008 (2008-12-31), XP002589146 Gefunden im Internet: URL:http://www.hsinyang.com.tw/angent/Non- contact%20Handling/2008_Product_OverviewAs ia_En.pdf [gefunden am 2010-06-28]

## Beschreibung

Die vorliegende Erfindung betrifft eine Vorrichtung bzw. ein Verfahren zum berührungslosen Erfassen von Glasplatten, insbesondere von Glasplatten der Größenordnung mehrerer Quadratmeter. Solche Glasplatten sind zum Beispiel aus der Photovoltaik bekannt und tragen oftmals eine berührungsempfindliche Beschichtung.

Aus dem Stand der Technik erscheinen folgende Druckschriften relevant.

Aus der DE 100 39482 A1 ist ein Handler zum Transportieren von flachen, in der Halbleiterindustrie zur Anwendung kommenden, Substraten, insbesondere Wafern, zwischen zwei Stationen, bekannt. Um bei diesem Transport die Berührung mit einer Auflagefläche weitgehend zu vermeiden, wird im Wesentlichen vorgeschlagen, dass ein Schwingungserzeuger zur Erzeugung einer longitudinalen Ultraschallschwingung mit einem Tragarm zusammenwirkt, sodass auf diesem Tragarm eine stationäre Schwingung mit mindestens einem Schwingungsbauch einstellbar ist, die eine Levitation eines darauf abgelegten Substrats ermöglicht. Weiter ist in dieser Druckschrift offenbart, dass Mittel zur Lagevorgabe des Substrats für eine laterale Positionierung durch ausschließlich eine Wechselwirkung mit dem Randbereich eines Substrats ausgebildet sind.
Zum berührungslosen Erfassen großer Glasplatten ist dieser Handler offensichtlich nicht geeignet.

In der DE 103 52 944 A1 wird eine Vorrichtung zum berührungslosen Transportieren, Handhaben und Lagern von Bauteilen und Materialien beschrieben, bei der zum Erzeugen eines Schwebezustandes durch Schallevitation eines Gegenstandes über einer schallabstrahlenden Fläche im Wesentlichen eine starre Stützkonstruktion, ein dünnes, parallel zur Stützkonstruktion angeordnetes, schwingungsfähiges Flächenelement und Schwingungserzeugungsmittel vorgeschlagen werden. Diese Vorrichtung soll einerseits eine Lagerung mittels Luftdüsen vermeiden, andererseits die bestehende Diskrepanz zwischen dem Verfahren der Schallevitation und den Anforderungen an eine Transportbahn und Lagervorrichtung überwinden. In der DE 103 52 944 A1 wird zwar beschrieben wie Bleche über einer Oberfläche in der Schwebe gehalten, fixiert und transportiert werden können, aber die Probleme beim berührungslosen Erfassen und Anheben großer Glasplatten entgegen der Schwerkraft sind mit dieser bekannten Vorrichtung ersichtlich nicht zu lösen.

Aus der DE 10 2007 016 840 A1 ist ferner eine Vorrichtung zum Transportieren und Halten von berührungsempfindlichen flachen Gegenständen und Materialien bekannt, die im Wesentlichen eine plattenförmige Aufnahme mit einem Schwingungserzeuger und wenigstens zwei Abstützelemente aufweist. Hinsichtlich der Lokalisierung des Schwingungserzeugers und der Abstützelemente, sowie der Frequenz des Schwingungserzeugers werden zusätzliche, im Prinzip lediglich eine Aufgabe formulierende, Angaben gemacht. Dieser Vorrichtung liegt das Ziel zugrunde, eine Technologie mittels Schallschwingungen bereitzustellen, die auch für den Transport und zum Halten nicht nur von kleinflächigen und leichten Bauteilen, wie z.B. Wafern, sondern auch für größer und schwerere als den vorhergehend genannten Bauteilen geeignet ist. Als Beispiel werden hierbei Glasplatten in der Größenordnung von einem Quadratmeter angegeben. In diesem Zusammenhang wird in der DE 10 2007 016 840 A1 darauf hingewiesen, dass die herkömmliche Technik, die für den Wafertransport entwickelt wurde, prinzipiell auch für den Transport größerer Bauteile geeignet wäre, wenn die Anzahl der Schwinger entsprechend erhöht und über die gesamte zu tragende Bodenfläche des Bauteils verteilt würde. Dazu wäre jedoch eine Vielzahl von separaten Schwingungssystemen erforderlich, die alle zueinander genau justiert werden müssten. Diese Maßnahmen würden eine erhebliche Verteuerung bedeuten. Abgesehen davon ist hier nur ein Transport in horizontaler Richtung möglich. Ein Anheben von Bauteilen entgegen der Schwerkraft ist mit dieser Vorrichtung nicht möglich.

Für das Erfassen und Anheben von Glasplatten in der Flächengröße von mehreren Quadratmetern ist diese Vorrichtung nicht konzipiert und auch deshalb nicht geeignet, weil Glasplatten von den Ausmaßen von mehreren Quadratmetern produktionsbedingt großflächige Unebenheiten aufweisen und sich zudem bei dem Anheben in der Mitte wegen ihres Eigengewichts nach allen Richtungen durchbiegen. Diese nicht vorhersehbaren Unebenheiten in Verbindung mit dem Vorgang des randseitigen Durchhängens machen den Einsatz der in der DE 10 2007 016 840 A1 beschriebenen Vorrichtung unmöglich.

In der DE 10 2006 017 763 A1 wird ein Dünnglasgreifer zum Halten und Umsetzen eines flächenartigen Werkstücks beschrieben, umfassend mehrere Greiferarme mit mindestens einem, jeweils daran angreifenden Saugheber, wobei die Greiferarme über einen gemeinsamen Anschlussflansch an eine Handhabungs- und Überführungseinrichtung und die Saugheber an eine Vakuumleitung anschließbar sind.

Diese Entwicklung soll einen Dünnglasgreifer bereitstellen, der ein schonendes Handling diverser Glasformate ermöglicht. Hierzu sind die Greiferarme des Dünnglasgreifers bezüglich des Anschlussflansches radial ausgerichtet und in ihrer axialen Richtung teleskopierbar. Ein berührungsloses Erfassen der Glasscheiben ist mit diesem Dünnglasgreifer nicht möglich.

Aus der Zeitschrift: "iwb newsletter", September 2007, Jahrgang 15, Nr.3,, ISSN 1434-324X, Seiten 3 und 4, ist die berührungslose Handhabung empfindlicher Bauteile mit Ultraschall-Vakuum-Greifern bekannt. Als Greifgut stehen hier kleine und leichte elektronische Bauteile wie elektrische Oberflächenwellenfilter im Vordergrund. Die berührungslose Handhabung großflächiger Glasplatten ist hier nicht behandelt.

In der EP 1 676 794 A1 ist eine Trageeinheit beschrieben, die mit positiver oder negativer Druckluft arbeiten kann und das Tragegut rasch und sicher absetzen kann. Das berührungslose Erfassen großflächiger Glasplatten ist hier nicht betroffen.

Aus der Druckschrift VERLAG MODERNE INDUSTRIE AG: "Berührungslos Greifen", 3. Dezember 2008, Gefunden im Internet: URL:http://imperia.mi-verlag.de/imperia/md/content/ ai/ae/fachartikel/pr/2008/12/pr08_12_050.pdf sind Vorrichtungen zur berührungslosen Handhabung flacher Objekte bekannt, die mittels Ultraschall arbeiten. Weiterhin zeigt die Druckschrift einen Ultraschallgreifer für Wafer oder Solarzellen, bei dem eine Kombination aus Ultraschall und Vakuum verwendet wird.

Weiterhin ist es aus der Druckschrift ZIMMERMANN & SCHILP: "NON-CONTACT HANDLING" 31. Dezember 2008, Gefunden im Internet: URL:http:// www.hsinyang.com.tw/angent/Non-contact%20Handling /2008_Product_OverviewAsia_En.pdf bekannt, berührungslose Greifer auf Basis der Ultraschallluftlager-Technologie zur Handhabung von Solarzellen oder Wafern einzusetzen bei denen durch Bohrungen in der Greiferfläche Luft abgesaugt und ein Vakuum erzeugt wird.

Der erfindungsgemäßen Vorrichtung, bzw. dem erfindungsgemäßen Verfahren liegt deshalb die Aufgabe zugrunde, ein berührungs-loses Erfassen und Anheben von berührungsempfindlichen Glasplatten in der flächenmäßigen Größenordnung mehrerer Quadratmeter auf wirtschaftliche und sichere, sowie kostengünstige Weise zu ermöglichen.

Diese Aufgabe wird gelöst hinsichtlich einer ersten, zweiten, dritten und vierten Vorrichtung durch die Merkmale nach Anspruch 1, Anspruch 2, Anspruch 3 bzw. Anspruch 4 sowie hinsichtlich des Verfahrens durch die Maßnahmen nach Anspruch 7.

Weitere vorteilhafte Ausgestaltungen der Erfindung ergeben sich aus den Unteransprüchen.

Die erfindungsgemäße Vorrichtung wird im Folgenden näher beschrieben. Es zeigen im Einzelnen:
- Fig.1 :: eine Draufsicht auf eine erfindungsgemäße Vorrichtung
- Fig.2:: eine Seitenansicht der Schwingplatte der Fig.1
- Fig.3:: eine verkleinerte Bauform der erfindungsgemäßen Vorrichtung
- Fig. 4:: eine alternative Konfiguration der Bauform nach Fig.3 b
- Fig.5:: eine erfindungsgemäße Anwendungsform der Strömung nach Bernoulli

Das grundlegende Funktionsprinzip der erfindungsgemäßen Vorrichtung beruht auf dem Zusammenwirken von Ultraschall und Unterdruck gegenüber der Umgebungsluft bei dem berührungslosen Erfassen von flächenförmigen Körpern, insbesondere Glasplatten. Auf diese Weise ist ein berührungsloses Anheben solcher Körper entgegen der Schwerkraft möglich. Zu diesem Zweck wird eine biegesteife Platte über einen Schwingungserzeuger in Schwingungen versetzt, an bestimmten Stellen der Unterseite dieser Platte wird hinsichtlich der Umgebungsluft ein Unterdruck erzeugt, und die Platte wird auf diese Weise berührungslos mit dem zu hebenden Körper verbunden. Da sich im Fall des Erfassens und Anhebens großflächiger, schwerer Glasplatten besondere Probleme ergeben, wurde erfindungsgemäß die vorliegende spezielle Vorrichtung geschaffen.

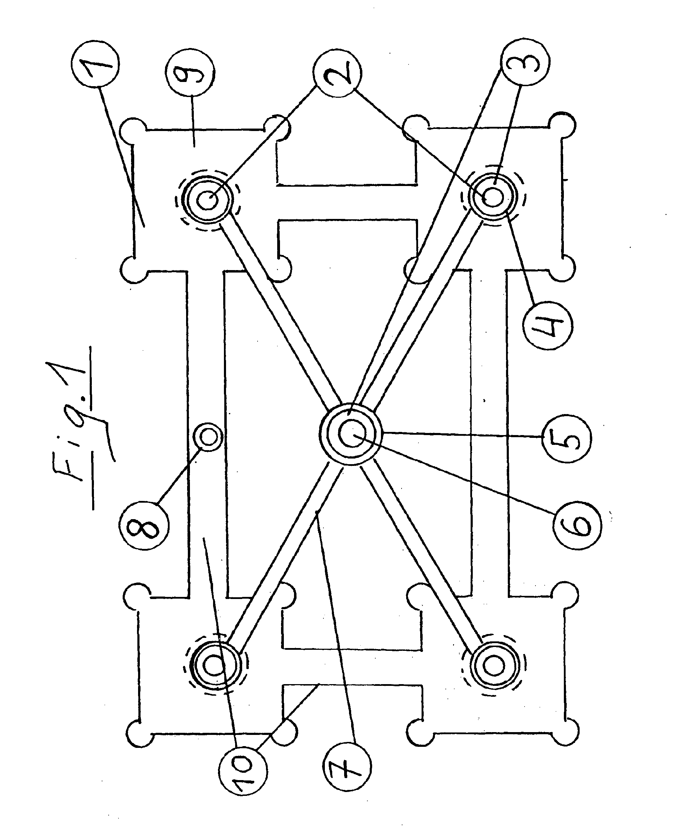

In der Fig.1 ist eine Draufsicht auf eine Schwingplatte 1 dargestellt. Die Schwingplatte 1 hat hierbei eine rechteckige Grundform, die in den vier Eckbereichen Teilflächen 9 mit einer jeweils im Wesentlichen quadratischen Ausgestaltung aufweist. Die vier quadratischen Teilflächen 9 bilden zusammen mit den zwei langen und den zwei kurzen Verbindungsstegen 10 eine einstückige Schwingplatte 1, an die ein Schwingungserzeuger 8 angekoppelt ist. Die vier quadratischen Teilflächen 9 weisen jeweils an ihren vier Ecken zungenartige Ausläufer auf die der

Harmonisierung des Schwingungsverlaufes dienen. Jede Teilfläche 9 weist in ihrem Zentrum ein Absaugrohr 2 auf, das auf der Unterseite der Teilfläche 9 jeweils in eine kreisförmige Aussparung mündet. Konzentrisch um ein Absaugrohr 2 ist ein, die Schwingung der Schwingplatte 1 absorbierendes, elastisches Material 3 gefügt, das jeweils von einem Haltering 4 umschlossen wird. An jeder Teilfläche 9 ist der Haltering 4 jeweils mit einem Verbindungsträger 7 verbunden. Alle vier Verbindungsträger 7 sind weiter oberhalb der Mitte der Schwingplatte 1 mit einem zentralen Dämpfungsgelenk 5 verbunden, an das sich die zentrale Befestigung 6 anschließt. Das zentrale Dämpfungsgelenk 5 weist ein weiteres, eine eventuelle Restschwingung dämpfendes, Material 3 auf und ist an der zentralen Befestigung 6 nach allen Seiten schwenkbar gelagert.

Dies betrifft eine wesentliche Funktion der erfindungsgemäßen Vorrichtung, da mit dieser Maßnahme gewährleistet ist, dass sich die Schwingplatte 1 insgesamt an Unebenheiten der Glasplatten anpassen kann. Denn es ist fertigungstechnisch bedingt, dass Glasplatten von den Ausmaßen von mehreren Quadratmetern naturgemäß großflächige Unebenheiten aufweisen und es ist mechanisch bedingt, dass sich solche Glasplatten bei dem Anheben in der Mitte wegen ihres Eigengewichts nach allen Richtungen durchbiegen.

Sollten es besondere Anforderungen notwendig erscheinen lassen kann in der Mitte der Schwingplatte nach der Fig.1 eine weitere Teilfläche 9 mit einem entsprechenden Absaugrohr 2 angefügt sein, die über zusätzliche Querstege 10 mit der Schwingplatte 1 verbunden ist. Hierfür wurde keine Figur gezeigt, da die entsprechende Konfiguration leicht nachvollziehbar erscheint.

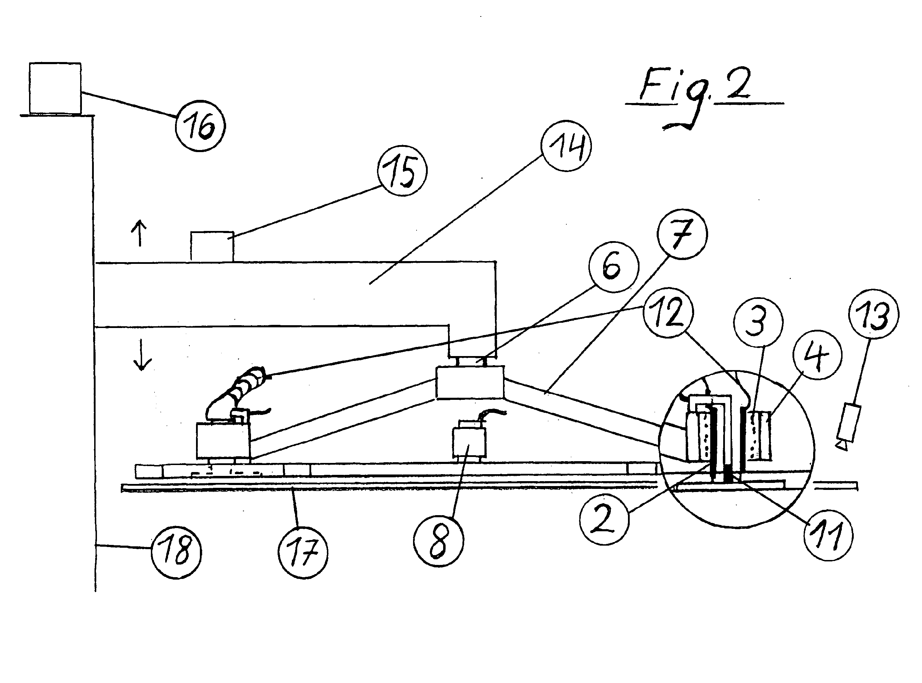

In der Seitenansicht der Fig.2 sind zwei Absaugrohre 2 mit jeweils einem Absaugschlauch 12 eingezeichnet, die zusammen mit den, in dieser Darstellung nicht sichtbaren, zwei weiteren Absaugrohren 2 und deren Absaugschläuchen 12 zu einer gemeinsamen, nicht extra gezeichneten, zentralen Absauganlage führen.

Als Beispiel für eine Möglichkeit der Absenkung der Schwingplatte 1 und der folgenden Anhebung der Schwingplatte 1 im Verbund mit einer aufgenommenen Glasplatte 17 ist in der Fig.2 die Hubsäule 18 mit dem, die Vorrichtung tragenden, Tragarm 14 dargestellt. Zur präzisen Bewegung des Tragarms 14 dient der Servoantrieb 16. Zur Steuerung des Servoantriebs 16 wird, insbesondere bei der Annäherung der Schwingplatte 1 an die Glasplatte 17, mindestens ein Abstandssensor 11 benötigt. Durch ihn wird ein notwendiges Rückkopplungssignal für die Steuerung geliefert. Wie in der Fig.2 in der Detail - Vergrößerung des eingezeichneten Kreises um den Haltering 4 gezeigt, ist ein solcher Abstandssensor 12 vorteilhaft in der Öffnung des Absaugrohrs 2 anzubringen. Vorteilhaft ist es ferner einen derartigen Abstandssensor 11 in jedem Absaugrohr 2 vorzusehen. Hierdurch werden mittels der zu erwartenden, im Detail unterschiedlichen, Ausgangssignale dieser Sensoren 11 zusätzliche Informationen erhalten. Aus diesen Unterschieden lassen sich zum Beispiel Rückschlüsse auf die Unebenheiten der Glasplatte 17 ziehen die dann im Steuergerät 15 verwertet und in einem Zentralrechner ausgewertet werden können. Aus der Geschwindigkeit der Änderung der Ausgangssignale dieser Abstandssensoren 11 bei der Annäherung an eine Glasplatte können wiederum wichtige Parameter zur Steuerung einer größeren Anlage mit mehreren Schwingplatten durch einen Zentralrechner gewonnen werden. In Vorversuchen ermittelte Standardwerte können als Parameter für die Programmstruktur der Steuerung verwendet werden.

In einem oder mehreren Absaugrohren 2 können ferner optische Sensoren 13 zur Detektion von Glasschäden der anzuhebenden Glasplatte 17 angebracht sein. Solche Sensoren .registrieren meist das durch Glasschäden verursachte Streulicht eingestrahlter Laserstrahlen. Beispielhaft für einen weiteren, außerhalb der Glasplatte installierten, Sensor ist in der Fig. 2 auf der rechten Seite zusätzlich ein Sensor 13 dargestellt. Die Auswahl, Anordnung und Ansteuerung solcher Sensoren hängt von der Konfiguration der jeweiligen Anlage ab. Diese Aufgabe ist dem Fachmann geläufig.

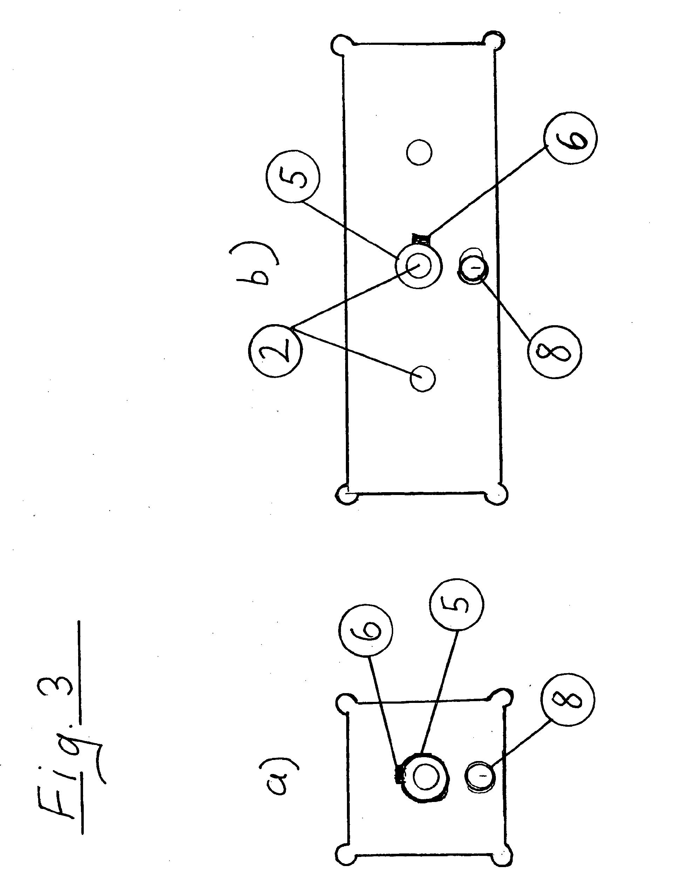

In der Fig. 3 sind verkleinerte Bauformen der erfindungsgemäßen Vorrichtung dargestellt. So entspricht in der Fig.3a die gezeigte Schwingplatte einer Teilfläche 9 der in der Fig.1 gezeigten Verbindung von vier Teilflächen 9. Da bei dem berührungslosen. Erfassen von großen Glasplatten unterschiedlichste Formate auftreten können, ist es notwendig für die Erfassung einer, zum Beispiel langen aber schmalen, Glasplatte mehrere Vorrichtungen hintereinander einzusetzen. Für diesen Zweck können mehrere Schwingplatten gemäß Fig.3a zur Bewältigung dieser Aufgabe verwendet werden. Je nach der Länge einer solchen Glasplatte mag es auch genügen eine Schwingplatte gemäß der Fig.3b einzusetzen.

Die zungenförmigen Ausbuchtungen sind dann an den Ecken der gesamten vorliegenden Konfiguration vorzusehen.

Es kann sich aber auch als zweckmäßig erweisen für die berührungslose Erfassung einer komplex strukturierten Glasplatte eine Kombination von Schwingplatten der Fig. 3a und der Fig.3b zu verwenden.

Für diese Fälle weisen jedoch die betreffenden Schwingplatten jeweils einen eigenen Schwingungserzeuger 8 und ein eigenes Absaugrohr 2 auf.

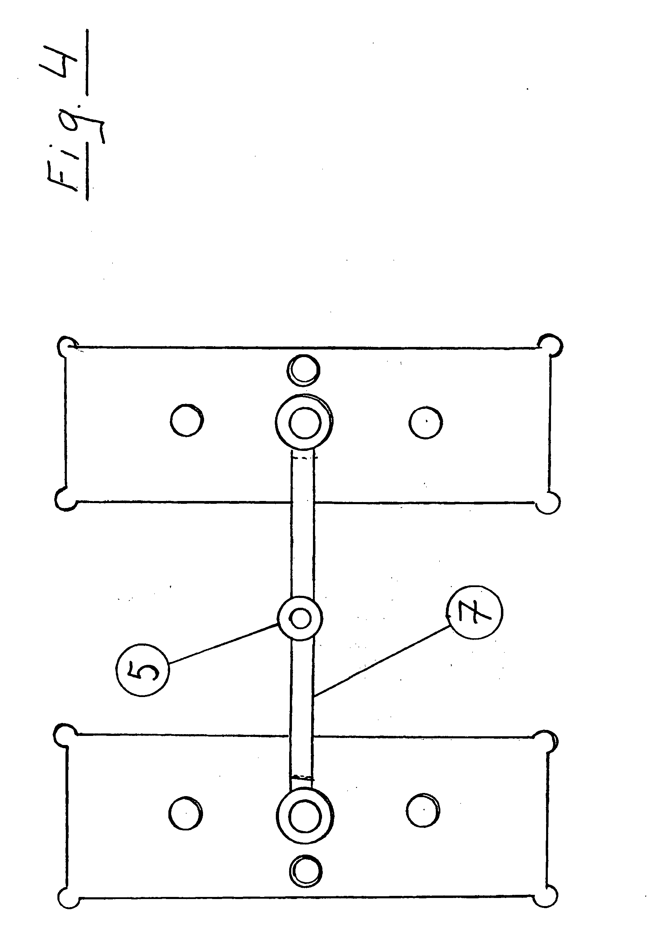

Fig.4 weist eine Alternative der Bauform nach Fig.3 b auf. Hier sind für den Fall einer besonders breiten Glasplatte zwei Schwingplatten nach der Konfiguration der Fig.3b mittels eines Verbindungsträgers 7 verbunden. In der Mitte dieser Bauform ist das zentrale Dämpfungsgelenk 5 als Teil einer Hebevorrichtung eingezeichnet.

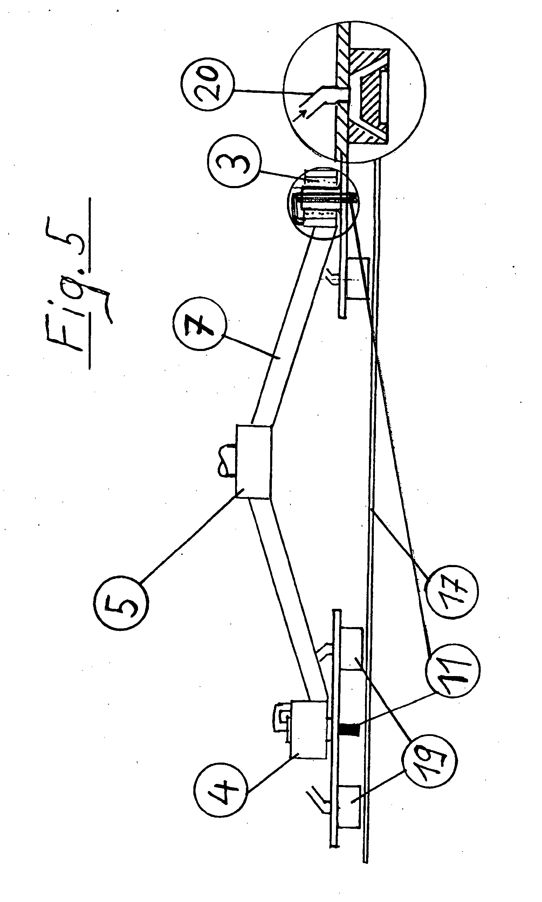

Fig.5 zeigt eine Anwendungsform der Strömung nach Bernoulli. Es ist nach dem Gesetz von Bernoulli bekannt, dass sich die Fließgeschwindigkeit eines durch ein Rohr strömenden inkompressiblen Fluids zu einem sich verändernden Rohrquerschnitt umgekehrt proportional verhält. Daraus folgt, dass bei dem in der Fig.5 im Kreis gezeigten Detail an der Unterseite in Relation zu der oben eingeblasenen Druckluft ein Unterdruck entsteht. Nach diesem Prinzip ist es ebenfalls möglich, wie in der Fig.5 im Querschnitt in Analogie zu der Fig.2 gezeigt, eine Glasplatte 17 entgegen der Schwerkraft anzuheben. Auch für diesen Fall ist das Drehgelenk 5 in Verbindung mit dem eingezeichneten Sensor 11 zur Lösung der, der Anmeldung zugrunde liegenden Aufgabe, notwendig.

Ein weiteres Levitatiohsprinzip besteht in der gezielten Anordnung von Zuluft und Abluft fördernden Austrittöffnungen einer Vorrichtung. Dies kann zu einem Gleichgewicht beider Luftströme führen das für Zwecke der Levitation verwendet werden kann. Dieser Effekt kann in Verbindung mit einer Platte, die, ähnlich wie bei dem beschriebenen Bernoulli - Greifer , anstelle von Absaugerohren eine Kombination von Zuluft- Rohren und Absaugerohren aufweist, die mittels vertieften Strömungskanälen verbunden sein können, erfindungsgemäß eingesetzt werden.

Da die erfindungsgemäße Vorrichtung als Teil einer großen Fertigungsanlage eingesetzt werden kann, bei der im raschen Wechsel Glasplatten unterschiedlichsten Formats mit meist empfindlicher Oberflächenbeschichtung berührungslos erfasst werden müssen, empfiehlt es sich in diesem Fall ein Magazin von Schwingplatten unterschiedlichster Größe vorzuhalten. Die hierfür notwendigen Vorrichtungen der an der Fertigungslinie bereitzustellenden Schwingplatten und der damit verbundenen Hebe - und Transportanlagen erfordern deshalb zusätzlich eine Vielzahl von Sensoren und Steuerungselementen.

Die interaktive Steuerung der jeweils verwendeten Bewegungselemente und Sensoren erfordert ein spezielles Steuerungsprogramm.

### Bezugszeichenliste

- (1): Schwingplatte
- (2): Absaugrohr
- (3): Elastisches Material
- (4): Haltering
- (5): Zentrales Dämpfungsgelenk
- (6): Zentrale Befestigung
- (7): Verbindungsträger
- (8): Schwingungserzeuger
- (9): Teilfläche
- (10): Verbindungssteg
- (11): Abstandssensor
- (12): Absaugschlauch
- (13): Optiksensor (Glasschaden - Sensor)
- (14): Tragarm
- (15): Steuergerät
- (16): Servoantrieb einer Hebevorrichtung
- (17): Glasplatte
- (18): Hubsäule
- (19): Bernoulli - Greifer
- (20): Druckluftleitung

## Patentansprüche

1. Vorrichtung zum berührungslosen Erfassen von Glasplatten, insbesondere von Glasplatten der Größenordnung mehrerer Quadratmeter, mit den folgenden Merkmalen:
a) wenigstens eine schwingungsfähige, rechteckige, plattenförmige, Schwingplatte (1) mit wenigstens einem Schwingungserzeuger (8), wobei die vier Ecken der Schwingplatte (1) von jeweils einer quadratischen Teilfläche (9) gebildet werden, und wobei jede dieser Teilflächen (9) an ihren vier Ecken zungenförmige Ausbuchtungen aufweist, und wobei die Teilflächen (9) miteinander durch Stege (10) verbunden sind,
b) jede Teilfläche (9) weist eine zentrale Öffnung zur Aufnahme eines, an der Oberseite installierten, Absaugrohrs (2) zur Luftabsaugung auf,
c) an der Unterseite jeder Teilfläche (9) ist eine kreisförmige, mit der zentralen Öffnung verbundene Aussparung vorgesehen,
d) die plattenförmige Schwingplatte (1) ist über vier, jeweils am Absaugrohr (2) einer Teilfläche (9) über einen Haltering (4) befestigte und in der Mitte der Schwingplatte (1) zusammengeführte Verbindungsträger (7) mit einem zentralen, nach allen Seiten schwenkbaren, Dämpfungsgelenk (5) verbunden,
e) das zentrale Dämpfungsgelenk (5) ist zur Entkopplung der verbliebenen systemeigenen Schwingung mit einer zentralen Befestigung (6) verbunden,
f) in mindestens einem Absaugrohr (2) ist ein Abstandssensor (11) zur Steuerung eines Servoantriebs (16) für die Annäherung der Schwingplatte (1) an die Glasplatte (17) untergebracht.

2. Vorrichtung zum berührungslosen Erfassen von Glasplatten, insbesondere von Glasplatten der Größenordnung mehrerer Quadratmeter, mit den folgenden Merkmalen:
a) wenigstens eine schwingungsfähige quadratische, plattenförmige Schwingplatte (1) mit wenigstens einem Schwingungserzeuger (8), wobei die Schwingplatte (1) an ihren vier Ecken zungenförmige Ausbuchtungen aufweist,
b) die Schwingplatte (1) weist eine zentrale Öffnung zur Aufnahme eines, an der Oberseite installierten, Absaugrohrs (2) zur Luftabsaugung auf,
c) an der Unterseite der Schwingplatte (1) ist eine kreisförmige, mit der zentralen Öffnung verbundene Aussparung vorgesehen,
d) die Schwingplatte (1) ist am Absaugrohr (2) über einen Haltering (4) mit einem Verbindungsträger (7) und mit einem zentralen, nach allen Seiten schwenkbaren, Dämpfungsgelenk (5) verbunden,
e) das zentrale Dämpfungsgelenk (5) ist zur Entkopplung der verbliebenen systemeigenen Schwingung mit einer zentralen Befestigung (6) verbunden,
f) in dem Absaugrohr (2) ist ein Abstandssensor (11) zur Steuerung eines Servoantriebs (16) für die Annäherung der Schwingplatte (1) an die Glasplatte (17) untergebracht.

3. Vorrichtung zum berührungslosen Erfassen von Glasplatten, insbesondere von Glasplatten der Größenordnung mehrerer Quadratmeter, mit den folgenden Merkmalen:
a) wenigstens eine schwingungsfähige rechteckige, plattenförmige Schwingplatte (1) mit wenigstens einem Schwingungserzeuger (8), wobei die Schwingplatte (1) an ihren vier Ecken zungenförmige Ausbuchtungen auf-weist,
b) die Schwingplatte (1) weist eine zentrale Öffnung und mindestens eine zusätzliche Öffnung zur Aufnahme jeweils eines, an der Oberseite installierten, Absaugrohrs (2) zur Luftabsaugung auf,
c) an der Unterseite der Schwingplatte (1) sind mindestens zwei kreisförmige, jeweils mit einer der Öffnungen verbundene Aussparungen vorgesehen,
d) die Schwingplatte (1) ist an dem zentralen Absaugrohr (2) über einen Haltering (4) mit einem Verbindungsträger (7) und mit einem zentralen, nach allen Seiten schwenkbaren, Dämpfungsgelenk (5) verbunden,
e) das zentrale Dämpfungsgelenk (5) ist zur Entkopplung der verbliebenen systemeigenen Schwingung mit einer zentralen Befestigung (6) verbunden,
f) in dem Absaugrohr (2) ist ein Abstandssensor (11) zur Steuerung eines Servoantriebs (16) für die Annäherung der Schwingplatte (1) an die Glasplatte (17) untergebracht.

4. Vorrichtung zum berührungslosen Erfassen von Glasplatten, insbesondere von Glasplatten der Größenordnung mehrerer Quadratmeter, mit den folgenden Merkmalen:
a) wenigstens zwei schwingungsfähige rechteckige, plattenförmige Schwingplatten (1) mit jeweils wenigstens einem Schwingungserzeuger (8), wobei die Schwingplatten (1) jeweils an ihren vier Ecken zungenförmige Ausbuchtungen aufweisen,
b) jede Schwingplatte (1) weist eine zentrale Öffnung und mindestens eine zusätzliche Öffnung zur Aufnahme jeweils eines, an der Oberseite installierten, Absaugrohrs (2) zur Luftabsaugung auf,
c) an der Unterseite jeder Schwingplatte (1) sind mindestens zwei kreisförmige, jeweils mit einer der Öffnungen verbundene Aussparungen vorgesehen,
d) die Schwingplatten (1) sind jeweils an dem zentralen Absaugrohr (2) über einen Haltering (4) miteinander über einen Verbindungsträger (7) und dieser ist wiederum über ein zentrales Dämpfungsgelenk (5) mit einem zentralen, nach allen Seiten schwenkbaren, Dämpfungsgelenk (5) verbunden,
e) das zentrale Dämpfungsgelenk (5) ist zur Entkopplung der verbliebenen systemeigenen Schwingung mit einer zentralen Befestigung (6) verbunden,
f) in den Absaugrohren (2) ist jeweils ein Abstandssensor (11) zur Steuerung eines Servoantriebs (16) für die Annäherung der Schwingplatte (1) an die Glasplatte (17) untergebracht.

5. Vorrichtung nach Anspruch 1,
**dadurch gekennzeichnet,**
**dass** in der Mitte der Schwingplatte (1) eine weitere,
ebenso ausgebildete Teilfläche (9) über mindestens zwei zusätzliche Querstege mit den Verbindungsstegen (10) verbunden ist.

6. Vorrichtung nach einem der Ansprüche 1 bis 4,
**dadurch gekennzeichnet,**
**dass** in mindestens einem Absaugrohr (2) und/oder im Bereich außerhalb einer Glasplatte (17) zusätzlich mindestens ein Optiksensor (13) zur Detektion von Glasschäden einer anzuhebenden Glasplatte (17) untergebracht ist.

7. Verfahren zum berührungslosen Erfassen von Glasplatten, insbesondere von Glasplatten der Größenordnung mehrerer Quadratmeter, mittels einer Vorrichtung nach einem der vorherigen Ansprüche, mit den folgenden Merkmalen:
a) über einer zu erfassenden Glasplatte (17) wird die biegesteife Schwingungsplatte (1) mittels des mindestens einen Schwingungserzeugers (8) in Schwingungen versetzt und an bestimmten Stellen der Unterseite der Schwingungsplatte (1) wird hinsichtlich der Umgebungsluft ein Unterdruck erzeugt,
b) die Schwingungsplatte (1) wird in den Nahbereich der Glasplatte (17) mittels des Abstandssensors (11) soweit abgesenkt, bis sich eine kraftschlüssige Verbindung zwischen der Schwingungsplatte (1) und der Glasplatte (17) ergibt,
c) die Schwingungsplatte (1) wird im Verbund mit der Glasplatte (17) angehoben,
d) die Schwingungsplatte (1) wird im Verbund mit der Glasplatte (17) am Zielort abgesetzt,
e) der mindestens eine Schwingungserzeuger (8) und der Unterdruck an der Schwingungsplatte (1) werden abgeschaltet und an einen neuen Einsatzort verbracht.

8. Verfahren nach Anspruch 7,
**dadurch gekennzeichnet,**
**dass** das Absenken der Schwingungsplatte (1) auf eine
Glasplatte (17) über den mindestens einen Abstandssensor (11) erfolgt, wobei dieser vorteilhaft in der Öffnung eines Absaugrohrs (2) angebracht wird, und wobei aus der Geschwindigkeit der Änderung der Ausgangssignale dieser Abstandssensoren (11) bei der Annäherung an eine Glasplatte (17) wichtige Parameter zur Steuerung einer größeren Anlage mit mehreren Schwingplatten (1) durch einen Zentralrechner gewonnen werden können.

9. Verfahren nach einem der Ansprüche 7 bis 8,
**dadurch gekennzeichnet,**
**dass** zum Betrieb in einer großen Fertigungsanlage ein Magazin von Schwingplatten (1) unterschiedlichster Größe vorgehalten wird.

## Claims

1. Apparatus for grasping glass plates, in particular glass plates having a size of several square meters, in a contactless manner, having the following features:
a) at least, one oscillatory, rectangular, plate-like oscillating plate (1) having at least one oscillation generator (8), wherein the four corners of the oscillating plate (1) are each formed by a square sub-surface (9), and wherein each of these sub-surfaces (9) has tongue-like protrusions at its four corners, and wherein the sub-surfaces (9) are connected together by crosspieces (10),
b) each sub-surface (9) has a central opening for receiving a suction pipe (2), installed on the upper side, for the suction extraction of air,
c) provided on the underside of each sub-surface (9) is a circular cutout which is connected to the central opening,
d) the plate-like oscillating plate (1) is connected to a central damping joint (5), which can pivot to all sides, via four connecting beams (7) which are each secured to the suction pipe (2) of a sub-surface (9) via a holding ring (4) and are brought together in the center of the oscillating plate (1),
e) the central damping joint (5) is connected to a central attachment (6) in order to decouple the remaining native oscillation,
f) a distance sensor (11) for controlling a servo drive (16) for moving the oscillating plate (1) in the direction of the glass plate (17) is accommodated in at least one suction pipe (2).

2. Apparatus for grasping glass plates, in particular glass plates having a size of several square meters, in a contactless manner, having the following features:
a) at least one oscillatory, square, plate-like oscillating plate (1) having at least one oscillation generator (8), wherein the oscillating plate (1) has tongue-like protrusions at its four corners,
b) the oscillating plate (1) has a central opening for receiving a suction pipe (2), installed on the upper side, for the suction extraction of air,
c) provided on the underside of the oscillating plate (1) is a circular cutout which is connected to the central opening,
d) the oscillating plate (1) is connected at the suction pipe (2) to a connecting beam (7) via a holding ring (4) and is connected to a central damping joint (5) which can pivot to all sides,
e) the central damping joint (5) is connected to a central attachment (6) in order to decouple the remaining native oscillation,
f) a distance sensor (11) for controlling a servo drive (16) for moving the oscillating plate (1) in the direction of the glass plate (17) is accommodated in the suction pipe (2).

3. Apparatus for grasping glass plates, in particular glass plates having a size of several square meters, in a contactless manner, having the following features:
a) at least one oscillatory, rectangular, plate-like oscillating plate (1) having at least one oscillation generator (8), wherein the oscillating plate (1) has tongue-like protrusions at its four corners,
b) the oscillating plate (1) has a central opening and at least one additional opening for receiving in each case a suction pipe (2), installed on the upper side, for the suction extraction of air,
c) provided on the underside of the oscillating plate (1) are at least two circular cutouts which are each connected to one of the openings,
d) the oscillating plate (1) is connected at the central suction pipe (2) to a connecting beam (7) via a holding ring (4) and is connected to a central damping joint (5) which can pivot to all sides,
e) the central damping joint (5) is connected to a central attachment (6) in order to decouple the remaining native oscillation,
f) a distance sensor (11) for controlling a servo drive (16) for moving the oscillating plate (1) in the direction of the glass plate (17) is accommodated in the suction pipe (2).

4. Apparatus for grasping glass plates, in particular glass plates having a size of several square meters, in a contactless manner, having the following features:
a) at least two oscillatory, rectangular, plate-like oscillating plates (1) each having at least one oscillation generator (8), wherein each oscillating plate (1) has tongue-like protrusions at its four corners,
b) each oscillating plate (1) has a central opening and at least one additional opening for receiving in each case a suction pipe (2), installed on the upper side, for the suction extraction of air,
c) provided on the underside of each oscillating plate (1) are at least two circular cutouts which are each connected to one of the openings,
d) the oscillating plates (1) are each connected together via a connecting beam (7) at the central suction pipe (2) via a holding ring (4) and said connecting beam is in turn connected via a central damping joint (5) to a central damping joint (5) which can pivot to all sides,
e) the central damping joint (5) is connected to a central attachment (6) in order to decouple the remaining native oscillation,
f) a distance sensor (11) for controlling a servo drive (16) for moving the oscillating plate (1) in the direction of the glass plate (17) is accommodated in each of the suction pipes (2).

5. Apparatus according to Claim 1,
**characterized**
**in that** in the center of the oscillating plate (1) a further sub-surface (9), which is formed in the same way, is connected to the connecting crosspieces (10) via at least two additional transverse crosspieces.

6. Apparatus according to one of Claims 1 to 4,
**characterized**
**in that** in addition at least one optical sensor (13) for detecting damage to the glass of a glass plate (17) to be lifted is accommodated in at least one suction pipe (2) and/or in the region outside a glass plate (17).

7. Method for grasping glass plates, in particular glass plates having a size of several square meters, in a contactless manner, by means of an apparatus according to one of the preceding claims, having the following features:
a) the at least one oscillation generator (8) is used to make the rigid oscillating plate (1) oscillate over a glass plate (17) to be grasped and a negative pressure with respect to the ambient air is generated at certain locations on the underside of the oscillating plate (1),
b) the oscillating plate (1) is lowered into the vicinity of the glass plate (17) by means of the distance sensor (11) until a force-fitting connection between the oscillating plate (1) and the glass plate (17) is achieved,
c) the oscillating plate (1) is lifted together with the glass plate (17),
d) the oscillating plate (1) is set down at the target location together with the glass plate (17),
e) the at least one oscillation generator (8) and the negative pressure at the oscillating plate (1) are switched off and transferred to a new point of use.

8. Method according to Claim 7,
**characterized**
**in that** the oscillating plate (1) is lowered onto a glass plate (17) via the at least one distance sensor (11), wherein the latter is advantageously fitted in the opening of a suction pipe (2) and wherein important parameters for controlling a relatively large installation having a plurality of oscillating plates (1) can be obtained by a central computer from the speed of the change in the output signals from said distance sensors (11) during the movement in the direction of a glass plate (17).

9. Method according to either of Claims 7 and 8,
**characterized**
**in that** a magazine of oscillating plates (1) of very different sizes is made available for operation in a large manufacturing installation.

## Revendications

1. Dispositif de préhension sans contact de panneaux de verre, en particulier de panneaux de verre d'un ordre de grandeur de plusieurs mètres carrés, comprenant les caractéristiques suivantes :
a) au moins une plaque oscillante (1) en forme de plaque rectangulaire, pouvant osciller, avec au moins un générateur d'oscillations (8), les quatre coins de la plaque oscillante (1) étant formés à chaque fois par une surface partielle quadrilatérale (9), et chacune de ces surfaces partielles (9) présentant, au niveau de ses quatre coins, des renflements en forme de langue, et les surfaces partielles (9) étant connectées les unes aux autres par des nervures (10),
b) chaque surface partielle (9) présente une ouverture centrale pour recevoir un tube d'aspiration (2) destiné à aspirer de l'air et installé sur le côté supérieur,
c) un évidement de forme circulaire connecté à l'ouverture centrale est prévu sur le côté inférieur de chaque surface partielle (9),
d) la plaque oscillante en forme de plaque (1) est connectée, par le biais de quatre supports de liaison (7) fixés à chaque fois sur le tube d'aspiration (2) d'une surface partielle (9) par le biais d'une bague de retenue (4) et rassemblés au centre de la plaque oscillante (1), à une articulation d'amortissement (5) centrale, pouvant pivoter vers tous les côtés,
e) l'articulation d'amortissement centrale (5) est connectée à une fixation centrale (6) en vue de découpler l'oscillation restante propre au système,
f) dans au moins un tube d'aspiration (2) est monté un capteur de distance (11) pour commander une servocommande (16) pour le rapprochement de la plaque oscillante (1) du panneau de verre (17).

2. Dispositif de préhension sans contact de panneaux de verre, en particulier de panneaux de verre d'un ordre de grandeur de plusieurs mètres carrés, comprenant les caractéristiques suivantes :
a) au moins une plaque oscillante (1) en forme de plaque quadrilatérale pouvant osciller, avec au moins un générateur d'oscillations (8), la plaque oscillante (1) présentant, au niveau de ses quatre coins, des renflements en forme de langue,
b) la plaque oscillante (1) présente une ouverture centrale pour recevoir un tube d'aspiration (2) destiné à aspirer de l'air et installé sur le côté supérieur,
c) un évidement de forme circulaire, connecté à l'ouverture centrale, est prévu sur le côté inférieur de la plaque oscillante (1),
d) la plaque oscillante (1) est connectée au niveau du tube d'aspiration (2), par le biais d'une bague de retenue (4), à un support de liaison (7) et à une articulation d'amortissement (5) centrale, pouvant pivoter vers tous les côtés,
e) l'articulation d'amortissement centrale (5) est connectée à une fixation centrale (6) en vue de découpler l'oscillation restante propre au système,
f) dans le tube d'aspiration (2) est monté un capteur de distance (11) pour commander une servocommande (16) pour le rapprochement de la plaque oscillante (1) du panneau de verre (17).

3. Dispositif de préhension sans contact de panneaux de verre, en particulier de panneaux de verre d'un ordre de grandeur de plusieurs mètres carrés, comprenant les caractéristiques suivantes :
a) au moins une plaque oscillante (1) en forme de plaque rectangulaire, pouvant osciller, avec au moins un générateur d'oscillations (8), la plaque oscillante (1) présentant, au niveau de ses quatre coins, des renflements en forme de langue,
b) la plaque oscillante (1) présente une ouverture centrale et au moins une ouverture supplémentaire pour recevoir à chaque fois un tube d'aspiration (2) destiné à aspirer de l'air et installé sur le côté supérieur,
c) au moins deux évidements de forme circulaire, connectés à chaque fois à l'une des ouvertures, sont prévus sur le côté inférieur de la plaque oscillante (1),
d) la plaque oscillante (1) est connectée au niveau du tube d'aspiration central (2), par le biais d'une bague de retenue (4), à un support de liaison (7) et à une articulation d'amortissement (5) centrale, pouvant pivoter vers tous les côtés,
e) l'articulation d'amortissement centrale (5) est connectée à une fixation centrale (6) en vue de découpler l'oscillation restante propre au système,
f) dans le tube d'aspiration (2) est monté un capteur de distance (11) pour commander une servocommande (16) pour le rapprochement de la plaque oscillante (1) du panneau de verre (17).

4. Dispositif de préhension sans contact de panneaux de verre, en particulier de panneaux de verre d'un ordre de grandeur de plusieurs mètres carrés, comprenant les caractéristiques suivantes :
a) au moins deux plaques oscillantes (1) en forme de plaques rectangulaires, pouvant osciller, avec à chaque fois au moins un générateur d'oscillations (8), les plaques oscillantes (1) présentant à chaque fois au niveau de leurs quatre coins des renflements en forme de langue,
b) chaque plaque oscillante (1) présente une ouverture centrale et au moins une ouverture supplémentaire pour recevoir à chaque fois un tube d'aspiration (2) destiné à aspirer de l'air et installé sur le côté supérieur,
c) au moins deux évidements de forme circulaire, connectés à chaque fois à l'une des ouvertures, sont prévus sur le côté inférieur de chaque plaque oscillante (1),
d) les plaques oscillantes (1) sont à chaque fois connectées l'une à l'autre au niveau du tube d'aspiration central (2) par le biais d'une bague de retenue (4) par le biais d'un support de liaison (7) et celui-ci est à son tour connecté par le biais d'une articulation d'amortissement centrale (5) à une articulation d'amortissement centrale (5) pouvant pivoter vers tous les côtés,
e) l'articulation d'amortissement centrale (5) est connectée à une fixation centrale (6) en vue de découpler l'oscillation restante propre au système,
f) dans les tubes d'aspiration (2) est monté à chaque fois un capteur de distance (11) pour commander une servocommande (16) pour le rapprochement de la plaque oscillante (1) du panneau de verre (17).

5. Dispositif selon la revendication 1,
**caractérisé en ce**
**qu'**une surface partielle (9) supplémentaire, réalisée de manière identique, au centre de la plaque oscillante (1), est connectée aux nervures de liaison (10) par le biais d'au moins deux nervures transversales supplémentaires.

6. Dispositif selon l'une quelconque des revendications 1 à 4,
**caractérisé en ce que**
dans au moins un tube d'aspiration (2) et/ou dans la région à l'extérieur d'un panneau de verre (17) est en outre monté au moins un capteur optique (13) pour détecter des endommagements du verre d'un panneau de verre (17) à soulever.

7. Procédé de préhension sans contact de panneaux de verre, en particulier de panneaux de verre d'un ordre de grandeur de plusieurs mètres carrés au moyen d'un dispositif selon l'une quelconque des revendications précédentes, comprenant les caractéristiques suivantes :
a) la plaque oscillante (1) rigide en flexion est mise à osciller au moyen de l'au moins un générateur d'oscillations (8) au-dessus d'un panneau de verre (17) à saisir, et une dépression par rapport à l'air ambiant est produite en des endroits déterminés du côté inférieur de la plaque oscillante (1),
b) la plaque oscillante (1) est abaissée à proximité du panneau de verre (17) au moyen du capteur de distance (11) jusqu'à ce qu'une liaison par engagement par adhérence se produise entre la plaque oscillante (1) et le panneau de verre (17),
c) la plaque oscillante (1) est soulevée conjointement avec le panneau de verre (17),
d) la plaque oscillante (1) est déposée à l'endroit souhaité conjointement avec le panneau de verre (17),
e) l'au moins un générateur d'oscillations (8) et la dépression appliquée à la plaque oscillante (1) sont déconnectés et amenés jusqu'à un nouveau lieu d'utilisation.

8. Procédé selon la revendication 7,
**caractérisé en ce que**
l'abaissement de la plaque oscillante (1) sur un panneau de verre (17) se produit par le biais de l'au moins un capteur de distance (11), celui-ci étant monté avantageusement dans l'ouverture d'un tube d'aspiration (2), et à partir de la vitesse de la variation des signaux de sortie de ces capteurs de distance (11) lors du rapprochement d'un panneau de verre (17), des paramètres importants pour la commande d'une plus grande installation avec plusieurs plaques oscillantes (1) pouvant être obtenus par un ordinateur central.

9. Procédé selon l'une quelconque des revendications 7 à 8,
**caractérisé en ce que**
pour le fonctionnement dans une grande installation de fabrication, on stocke un magasin de plaques oscillantes (1) de tailles différentes.
